# EUROPEAN PATENT APPLICATION

(11) **EP 4 395 498 A1**
(43) Date of publication of application: **03.07.2024**
(21) Application number: 23215645.5
(22) Date of filing: 11.12.2023
(51) Int. Cl.: H10K 50/115, H10K 71/20, H10K 85/50

(54) **PEROVSKITE PATTERNED FILM AND PREPARATION METHOD AND APPLICATION THEREOF**

(30) Priority: 26.12.2022 CN 202211676100
(71) Applicant: Leyard Optoelectronic Co., Ltd., Beijing 100091 (CN)
(72) Inventor: YANG, Xiaoyu, Haidian District Beijing, 100091 (CN); MA, Li, Haidian District Beijing, 100091 (CN); LU, Changjun, Haidian District Beijing, 100091 (CN)
(74) Representative: V.O.

(57) **Abstract**

The disclosure provides a perovskite patterned film and a preparation method and application thereof. The preparation method comprises the following steps: coating a PbX₂ precursor on a substrate, and annealing to obtain a PbX₂ film substrate; coating AY salt on the nano stamp with the pattern, and annealing to obtain an AY film nano stamp; carrying out nanoimprinting to obtain an APb(X,Y)s perovskite patterned film. According to the method, the perovskite pattern is accurately constructed on the PbX₂ substrate in a mode of combining contact imprinting and ion diffusion, the PbX₂/perovskite/PbX₂ coplanar surface smooth thin film is obtained, the perovskite pattern serves as an active area, the rest PbX₂ naturally serves as a wide-band-gap insulation/inert isolation material, the residual rate of the thin film is low, and the yield is greatly improved.

## Description

### Technical Field

The present disclosure relates to the technical field of optoelectronic materials, in particular to a perovskite patterned film and preparation method and application thereof.

### Background

Lead-halide perovskite materials, as a new generation of organic-inorganic hybrid semiconductor materials, have attracted widespread attentions in related fields and are widely used in the field of optoelectronics such as photovoltaics, light-emitting diodes, photodetector, laser, etc. In particular, the certified efficiency of solar cells based on perovskites has reached over 25%, which can be comparable to commercial silicon-based solar cells. Therefore, the studies of perovskite materials/films in various fields of optoelectronic applications are still in full swing. Among them, the patterning technology for perovskite films has always been a focus of attention in the field, and the facile processing to achieve high-quality perovskite patterns will become a promising technique in the future semiconductor technology.

The patterning technologies for perovskites are mainly divided into two categories: bottom-up growth methods and top-down etching methods. Among them, the top-down etching method involves electron/ion beam etching of as-formed perovskite materials to construct patterns. However, the perovskite belongs to the ionic semiconductor, and etching will greatly reduce the quality of the perovskite patterns, which is not suitable for the processing of perovskite materials. The bottom-up growth methods can also be divided into inkjet printing method, laser direct writing method, nanoimprinting method, substrate pre-patterning method, and template-assisted method. The inkjet printing method has higher requirements for equipment and possesses poor qualities and resolution of perovskite patterned units. The patterns prepared by laser direct writing method are flexible, however, the perovskite has poor and uncontrollable quality. The perovskite pattern prepared by the substrate pre-patterning method has good quality and controllable growth conditions, however the pre-patterning process is complex and has special requirements for the substrate. The template-assisted method usually targets at the perovskite patterns constructed through evaporation method, however the perovskite materials obtained through evaporation has poor quality. Therefore, in summary, the nanoimprinting method can ensure the quality of the perovskite patterns and has a simple and low cost process, making it one of the preferred methods for processing the perovskite materials.

The nanoimprinting method involves the utilization of the perovskite materials/films to grow in a solution condition, as well as imprinting and localizing the liquid film in the "soft" state to obtain the desired perovskite pattern. However, it is difficult for the traditional nanoimprinting methods to ensure that whether there is excess residue on the substrate after imprinting, and the peeling process also has a certain impact on the yield of the pattern. In addition, the repeated peeling also needs complex subsequent cleaning steps, which is not conducive to their large-scale patterned preparation. The most crucial thing is that the traditional nanoimprinting methods cannot avoid the residual issues, and precise pressure control is required during the imprinting process to avoid the growth of unnecessary perovskite residues at non-preset pattern positions; at the same time, the peeling process will also affect the quality and yield of the patterns. During the localized growth process, the perovskite tends to nucleate and grow adhering to the stamp wall. Therefore, the peeling process is likely to affect the already formed patterns, thereby reducing the yield of the final patterns, and the entire process is relatively complex. Chinese patent CN 114122266 A disclosed a preparation method of a surface-patterned organic-inorganic hybrid perovskite thin film. The method involved spin-coating a metal-halide precursor onto a substrate, then imprinting a liquid-like metal-halide intermediate thin film with a patterned stamp, peeling off, annealing and crystallization, and then sprinkling the MAX powder thereon, heating and reacting same to obtain a perovskite thin film. However, it uses soft template imprinting technology combined with gas assisted method, which is a complex process and makes it difficult to control the quality of the prepared patterns; meanwhile, the patterned structure prepared by this method is a convex structure, and the subsequent preparation of thin film optoelectronic devices requires preparation of an additional intermediate insulation layer, which is complex and easy to affect the quality of the perovskite patterns. In addition, the traditional nanoimprinting method follows the process of early patterning methods for organic materials, while for perovskite materials, there is an urgent need to develop a nanoimprinting technology that is suitable for perovskite materials and utilizes the characteristics of perovskites.

### Summary

The main object of the present disclosure is to provide a perovskite patterned film and preparation method and application thereof, so as to solve the problems of excessive residue, low pattern yield, and complex preparation process of optoelectronic devices when using nanoimprinting for perovskite patterning in the prior art.

In order to achieve the above object, according to an aspect of the present disclosure, a preparation method of a perovskite patterned film is provided, which includes the following steps: step S1, coating a PbX₂ precursor on a substrate, and carrying out a first annealing to obtain a PbX₂ film substrate; step S2, coating AY salt on the nano stamp with the pattern, and carrying out a second annealing to obtain an AY film nano stamp; step S3, carrying out nanoimprinting on the PbX₂ film substrate through the AY film nano stamp to obtain an APb(X,Y)₃ perovskite patterned film; wherein X and Y are respectively and independently one or more of I, Br and Cl, and the AY salt includes amine salt and/or Cs-based salt.

Further, the PbX₂ precursor includes PbX₂ and/or PbX₂ derivative, and the PbX₂ derivative includes PbX₂-DMSO and/or PbX₂-NMP.

Further, the AY salt includes one or more of MAY, FAY, and CsY

Further, the substrate material includes one or more of transparent conductive glass, oxide, and organic polymer, and the nano stamp material includes one or more of PDMS, PMMA, and Al₂O₃; preferably, the transparent conductive glass includes one or more of ITO, FTO, and IZO; the oxide includes one or more of Al₂O₃, TiO₂, SnO₂, and ZnO; and the organic polymer material includes one or more of PMMA, PDMS, and PEIE; and more preferably, the substrate material is one or more of ITO, ZnO, and PEIE.

Further, in the step S1, the first annealing is carried out at a temperature of 60 to 80°C for a time of 0.5 to 2 minutes.

Further, in the step S2, the second annealing is carried out at a temperature of 50 to 70°C for a time of 0.5 to 2 minutes; preferably, before coating the AY salt, it further includes the step of carrying out a hydrophilic treatment on the surface of the nano stamp with the pattern; and more preferably, the hydrophilic treatment is to perform the ultraviolet and ozone treatments for 5 to 15 minutes.

Further, in the step S3, the nanoimprinting is applied at a pressure of 0 to 100 MPa, preferably 0.5 to 2 MPa for a time of 0.5 to 2 minutes; preferably, the step S3 further includes a third annealing; and more preferably, the third annealing is carried out at a temperature of 70 to 300°C, preferably 80 to 120°C, for a time of 3 to 7 minutes.

According to another aspect of the present disclosure, a perovskite patterned film is provided, which is obtained by the preparation method of the present disclosure.

According to another aspect of the present disclosure, application of the aforementioned perovskite patterned film in an optoelectronic device is provided.

According to another aspect of the present disclosure, a optoelectronic device is provided, including the aforementioned perovskite patterned film; and preferably, the optoelectronic device is a solar cell, a Micro-LED, a Mini-LED, or an OLED.

According to the present disclosure, a unique "in situ two-step synthesis method" patterning method of perovskite based on nanoimprinting to achieve the preparation of a coplanar perovskite patterned structure is designed on the basis of the specific film-forming method of perovskite materials.

Firstly, the preparation method of the present disclosure takes full advantage of the ion migration characteristics of organic lead halide perovskite materials and the wide-band-gap inertness of precursor PbX₂, wherein the nano stamp is used as the diffusion substrate of AY salt, and the perovskite pattern is accurately constructed on the PbX₂ substrate in a mode of combining contact imprinting and ion diffusion, so that the PbX₂/perovskite/PbX₂ coplanar structure is smoothly formed, where the perovskite pattern serves as an active area, while the rest PbX₂ naturally serves as a wide-band-gap insulation/inert isolation material.

Secondly, the preparation method of the present disclosure involves in-situ growth of perovskite patterns through a two-step synthesis method, which can fundamentally avoid the residual and peeling problems that are prone to occur in the traditional nanoimprinting methods, resulting in a low residual rate and greatly improved yield of the obtained patterns.

Thirdly, the preparation method of the present disclosure is simple, and the obtained perovskite patterned film is a coplanar surface smooth thin film, which can be directly used for the preparation of optoelectronic devices without any smoothing treatment subsequently and can be applied to various optoelectronic devices such as Mini/Micro-LED, solar cells, and optoelectronic detector, etc., and has a wide range of applications.

### Brief Description of the Drawings

The accompanying drawings of the description, which form a part of the application, are used to provide a further understanding of the disclosure. The illustrative embodiments and their descriptions of the disclosure are used to explain the disclosure, and do not constitute an improper limitation thereto. In the accompanying drawings:
Fig. 1 shows a flow diagram of a preparation process for a perovskite patterned film according to an example of the present disclosure;
Fig. 2 shows a flow diagram of a preparation process for a perovskite Micro-LED device according to an example of the present disclosure; and
Fig. 3 shows a photograph of a Micro-LED device with a perovskite patterned film according to example 1 of the present disclosure.

Wherein, the above drawings include the following reference symbols:
1, PbX₂; 2, AY salt; 3, Perovskite APb(X,Y)₃; S1, Coating of PbX₂ precursor film; S2, Coating of AY salt film; S3, Nanoimprinting; A, Substrate; B, Nano stamp; C, Perovskite patterned film; D, Top transport layer; E, Driving part; F, Perovskite Micro-LED; G, Controlling of illumination via driving part.

### Detailed Description of the Embodiments

It should be noted that the examples and features in the examples in the application can be combined with each other without conflicting. The disclosure will be described in detail below with reference to the drawings and in combination with examples.

As stated in the background technology of the present disclosure, there are problems of excessive residue, and low pattern yield when using nanoimprinting for perovskite patterning in the prior art. In order to solve the above problems, in a typical embodiment of the present disclosure, a preparation method of a perovskite patterned film is provided, which includes the following steps: step S1, coating a PbX₂ precursor on a substrate, and carrying out a first annealing to obtain a PbX₂ film substrate; step S2, coating AY salt on the nano stamp with the pattern, and carrying out a second annealing to obtain an AY film nano stamp; step S3, carrying out nanoimprinting on the PbX₂ film substrate through the AY film nano stamp to obtain an APb(X,Y)₃ perovskite patterned film; wherein X and Y are respectively and independently one or more of I, Br and Cl, and the AY salt includes amine salt and/or Cs-based salt.

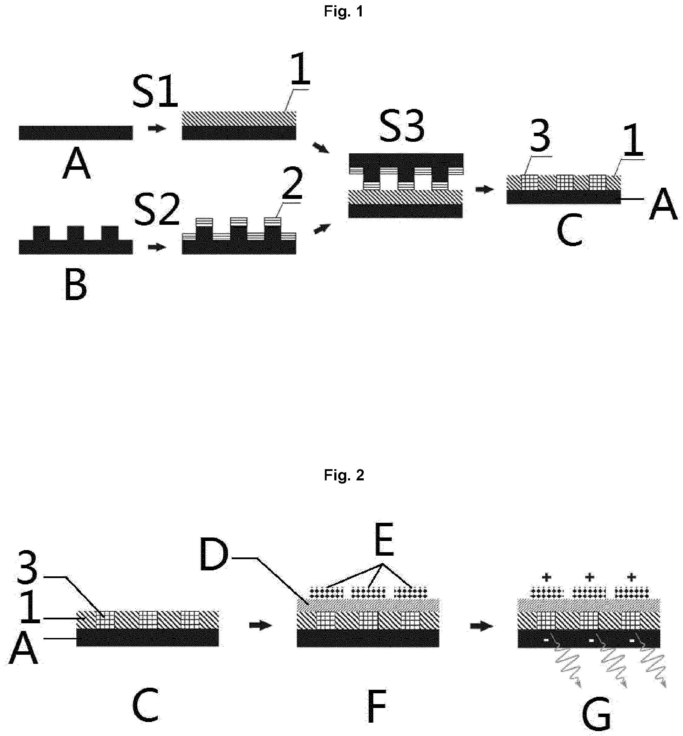

Targeting at the patterning technology of perovskite films/monocrystals and facing the optoelectronic applications such as luminescence, detection, and photovoltaics, etc., the present disclosure designs a unique "in situ two-step synthesis method" patterning method of perovskite based on nanoimprinting to achieve the preparation of a coplanar perovskite patterned structure on the basis of the specific film-forming method of perovskite materials, i.e., a two-step ion intercalation film-forming method. Specifically, as shown in Fig. 1 and Fig. 2, the coating of PbX₂ precursor film S1 is performed, including firstly coating the PbX₂ precursor on a pre-fabricated substrate and performing a first annealing to obtain a PbX₂ film substrate with good and stable substrate contact, where a substrate A and PbX₂ 1 coated thereon are included; then the coating of AY salt film S2 is performed, including coating AY salt on a pre-fabricated nano stamp with the pattern and performing a second annealing, at this time both the convex and concave parts of the stamp will be deposited with AY film, so that the AY film nano stamp is obtained, where a nano stamp B and AY salt 2 coated thereon are included. Among them, the convex part of the nano stamp is the perovskite pattern to be constructed.

Finally, the nanoimprinting S3 is carried out, including nanoimprinting the PbX₂ film substrate through the AY film nano stamp, with the AY film of the convex part of nano stamp contacted with the PbX₂ film on the substrate to allow AY to properly diffuse and generate perovskite in the PbX₂ film, which takes full advantage of the ion migration characteristics of organic lead halide perovskite materials and the wide-band-gap inertness of precursor PbX₂, wherein the nano stamp is used as the diffusion substrate of AY salt, and the perovskite pattern is accurately constructed on the PbX₂ substrate in a mode of combining contact imprinting and ion diffusion, so that the PbX₂/perovskite/PbX₂ coplanar structure is smoothly formed, where the perovskite pattern serves as an active area, while the rest PbX₂ naturally serves as a wide-band-gap insulation/inert isolation material. After the full diffusion reaction is completed, the nano stamp is directly removed to obtain an inert wide-band-gap PbX₂ protected APb(X,Y)₃ perovskite patterned film C, with the pattern part being the generated perovskite APb(X,Y)₃ 3.

After the preparation is completed, the top transport layer D and driving part E can be provided on the perovskite patterned film as desired, such as driving electrodes or driving circuits, so as to obtain a patterned optical device, such as perovskite Micro-LED F, which can performing controlling of illumination via driving part G.

The preparation method of the present disclosure is a unique patterning method for perovskite materials, which utilizes two key points: the high ion migration ability of perovskite, and the precursor PbX₂ as a wide-band-gap optoelectronic inert material. In-situ growth of perovskite patterns through a two-step synthesis method can fundamentally avoid the residual and peeling problems that are prone to occur in the traditional nanoimprinting methods, resulting in a low residual rate and greatly improved yield of the obtained patterns. Moreover, the preparation method is simple, and the obtained perovskite patterned film is a coplanar film with negligible undulations, which can be directly used for the further assembly of patterned, pixelated, and arrayed optoelectronic devices without any smoothing treatment subsequently, is more convenient for the preparation of optoelectronic devices subsequently, and can be applied to various optoelectronic devices such as Mini/Micro-LED, solar cells, and optoelectronic detector, etc., and has a wide range of applications.

In a preferred embodiment, the PbX₂ precursor includes PbX₂ and/or PbX₂ derivative, and the PbX₂ derivative includes coordination compounds such as PbX₂-DMSO and/or PbX₂-NMP, etc. Selection of the PbX₂ precursor mentioned above is mainly based on two points. On the one hand, PbX₂ precursor is an essential reaction precursor for perovskite materials, which will provide a precursor matrix for subsequent two-step nanoimprinting; on the other hand, the aforementioned PbX₂ precursor is a wide-band-gap semiconductor material, which can naturally form an electrical insulation layer and has good optoelectronic inertness, and thus it is conducive to simplifying the preparation process of subsequent optoelectronic devices. In view of the above, it can further improve the yield of perovskite patterns. Among them, depending on different raw materials, the coating methods of PbX₂ precursor can be selected from conventional methods, including but not limited to spin coating, blade coating, slit coating, and vacuum evaporation methods, etc.

The above-mentioned AY salt includes a series of materials such as amine salts and Cs-based salts, etc., that can meet the ABX₃ perovskite-type tolerance factor. In a preferred embodiment, the AY salt includes one or more of MAY (methylamine salt), FAY (formamidine salt), and CsY The above-mentioned AY salt is accessible, has a lower cost, and has better ion migration ability in the PbX₂ precursor films, which can further improve the yield of perovskite patterns. Among them, depending on different raw materials, the coating methods of AY salt can be selected from conventional methods, including but not limited to spin coating, blade coating, slit coating, and vacuum evaporation methods, etc.

The above-mentioned substrate materials include but are not limited to one or more of various organic or inorganic materials such as insulation and semiconductor materials, etc. In a preferred embodiment, the substrate material includes one or more of transparent conductive glass, oxide, and organic polymer, and the nano stamp materials include one or more of PDMS, PMMA, and Al₂O₃; the above-mentioned nano stamp materials have better wettability, which can further ensure that the coated AY film is sufficiently uniform, and the patterns of the nano stamp can be prepared using common pattern etching preparation processes such as photolithography or electron beam etching, etc.

Preferably, the transparent conductive glass includes one or more of ITO, FTO, and IZO; the oxide includes one or more of Al₂O₃, TiO₂, SnO₂, and ZnO; the organic polymer material includes one or more of PMMA, PDMS, and PEIE; the above mentioned substrate materials have better wettability, and can further ensure that a uniform and dense thin film can be obtained from the PbX₂ thereon. More preferably, the substrate material is one or more of ITO, ZnO, and PEIE, which has better compatibility with the PbX₂ of the present disclosure. In addition, to meet the requirements for the preparation of optoelectronic devices subsequently, the substrate can be of a pre-prepared device structure.

In a preferred embodiment, in the step S1, the first annealing is carried out at a temperature of 60 to 80 °C for a time of 0.5 to 2 minutes. The above annealing regime can obtain a PbX₂ film with better contact with the substrate, further increasing the stability of the PbX₂ film substrate.

Correspondingly, in a preferred embodiment, in the step S2, the second annealing is carried out at a temperature of 50 to 70 °C for a time of 0.5 to 2 minutes, so that the convex and concave parts of the nano stamp can be more fully and uniformly deposited with the AY film.

Preferably, before coating the AY salt, it further includes the step of carrying out a hydrophilic treatment on the surface of the nano stamp with the pattern; more preferably, the hydrophilic treatment is to perform the ultraviolet and ozone treatments for 5 to 15 minutes. The aforementioned hydrophilic treatment can further improve the wettability of the surface of nano stamp, resulting in a more evenly coated AY film, which facilitates the smooth formation of patterns in the subsequent imprinting reaction process.

The pressure applied in the above-mentioned nanoimprinting method can be adjusted according to different perovskite components. In a preferred embodiment, in the step S3, the nanoimprinting is applied at a pressure of 0 to 100 MPa, preferably 0.5 to 2 MPa for a time of 0.5 to 2 minutes, which can make the AY film on the surface of nano stamp more fully contact with the PbX₂ film on the surface of substrate, thereby allowing AY to diffuse more properly in the PbX₂ film, further smoothly forming a PbX₂/perovskite/PbX₂ coplanar structure with a smooth surface.

Preferably, the step S3 further includes a third annealing, and the annealing regime can be adjusted as needed for different perovskite components; more preferably, the third annealing is carried out at a temperature of 70 to 300 °C, preferably 80 to 120 °C, for a time of 3 to 7 minutes, which can further accelerate the ion migration of the AY film and perovskite phase formation. It should be noted that according to different experimental environments and conditions, those skilled in the art can choose to perform a third annealing during the nanoimprinting process or perform a third annealing after the nanoimprinting.

In yet another typical embodiment of the present disclosure, a perovskite patterned film is also provided, which is obtained by the preparation method of the present disclosure, wherein the perovskite pattern serves as the active area, while the rest PbX₂ naturally serves as a wide-band-gap insulation/inert isolation material, and thus the perovskite patterned film has few residues and high yield.

In yet another typical embodiment of the present disclosure, application of the aforementioned perovskite patterned film in an optoelectronic device is also provided, including but not limited to applications in optoelectronic devices such as Mini/Micro-LED, solar cells, and optoelectronic detectors, etc. The above perovskite patterned film can be further subjected to the preparation of subsequent transport layer or functional layer so as to construct the optoelectronic devices. Due to the fact that the APb(X,Y)₃ perovskite/PbX₂ patterned film obtained by the imprinting method of the present disclosure is almost a coplanar film with negligible undulations, the subsequent coating of the transport layer can be carried out without any smoothing treatment, which is further combined with the patterned electrodes or driving electrodes to obtain the patterned, pixelated, and arrayed optoelectronic devices.

In yet another typical embodiment of the present disclosure, a optoelectronic device is also provided, including the aforementioned perovskite patterned film; and preferably, the optoelectronic device is a solar cell, a Micro-LED, a Mini-LED, or an OLED.

The application will be further described in detail below in combination with specific examples, which cannot be understood as limiting the scope of protection claimed in the application.

### Example 1 MAPbl₃ patterned film

Step 1, Pbl₂ film substrate and MAI film nano stamp were prepared. 0.5 M of Pbl₂ solution (solvent DMF:DMSO = 9:1) was spin coated onto the prepared ITO/ZnO/PEIE composite transparent conductive substrate, with spin coating parameters of 1500 rpm, 1000 rpm/s, and 30 s. After the spin coating was completed, annealing at 70 °C for a time period of 1 minute was accompanied to complete the preparation of Pbl₂ film substrate. For the preparation of MAI film, it was necessary to firstly treat the surface of the PMMA nano stamp with ultraviolet and ozone treatment methods for 10 minutes to improve the wettability of the surface, then a solution 3M of MAI in IPA was deposited on the surface of the PMMA nano stamp through a spin coating method, with spin coating parameters of 2000 rpm, 1000 rpm/s, and 60 s. After the spin coating was completed, annealing at 60 °C for a time period of 1 minute was accompanied to complete the preparation of MAI film nano stamp.

Step 2, MAPbl₃ patterned film was prepared using the perovskite nanoimprinting. The substrate coated with Pbl₂ film was contacted with the nano stamp coated with MAI film, and a pressure of 0.5 MPa was applied for 1 minute, which was then annealed at 100°C for 5 minutes. After the annealing was completed, the nano stamp was separated from the substrate to obtain the perovskite MAPbl₃ patterned film.

Step 3, the LED device based on MAPbl₃ patterned film was prepared. A TPB transport layer was coated on the perovskite MAPbl₃ patterned film and a hole transport (blocking layer) layer of 7 nm MoOs was evaporated, subsequently 80 nm of Au was evaporated as the driving electrode to obtain a patterned MAPbl₃ red light LED device.

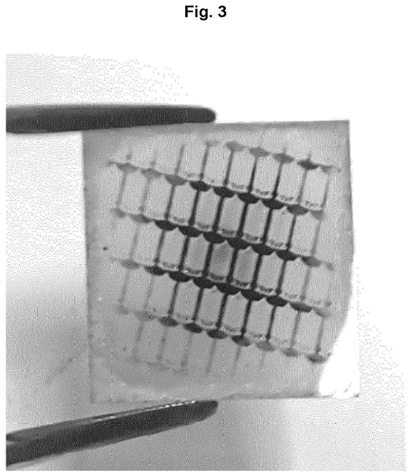

The photograph of the Micro-LED device with the perovskite patterned film prepared in Example 1 is shown in Fig. 3.

### Example 2

The difference between Example 2 and Example 1 lied in that in the step 1, the precursor Pbl₂ of MAPbl₃ film was replaced with PbBr₂, and MAI was replaced with MABr, so as to obtain a perovskite MAPbBrs patterned film and a patterned MAPbBr₃ green light LED device.

### Example 3

The difference between Example 3 and Example 1 lied in that in the step 3, the full-face Au electrode was replaced with a driving electrode with corresponding patterns to obtain a perovskite MAPbl₃ patterned film and a driving circuit-controllable perovskite Micro-LED device.

### Example 4

The difference between Example 4 and Example 1 lied in that in the step 1, the concentration of Pbl₂ precursor was increased to 1.3 M, ZnO/PEIE was replaced with SnO₂, and in the step 3, the TFB/MoOs transport layer was replaced with Spiro-OMeTAD, so as to obtain a perovskite MAPbl₃ patterned film and a patterned MAPbl₃ solar cell device.

### Example 5 MAPbl₃ patterned film

Step 1, Pbl₂ film substrate and MAI film nano stamp were prepared. 0.5 M of Pbl₂ solution (solvent DMF:DMSO = 9:1) was spin coated onto the prepared ITO/ZnO/PEIE composite transparent conductive substrate, with spin coating parameters of 1500 rpm, 1000 rpm/s, and 30 s. After the spin coating was completed, annealing at 60 °C for a time period of 2 minutes was accompanied to complete the preparation of Pbl₂ film substrate. For the preparation of MAI film, it was necessary to firstly treat the surface of the PMMA nano stamp with ultraviolet and ozone treatment methods for 5 minutes to improve the wettability of the surface, then a solution 3M of MAI in IPA was deposited on the surface of the PMMA nano stamp through a spin coating method, with spin coating parameters of 2000 rpm, 1000 rpm/s, and 60 s. After the spin coating was completed, annealing at 50°C for a time period of 2 minutes was accompanied to complete the preparation of MAI film nano stamp.

Step 2, MAPbl₃ patterned film was prepared using the perovskite nanoimprinting. The substrate coated with Pbl₂ film was contacted with the nano stamp coated with MAI film, and a pressure of 0.5 MPa was applied for 2 minutes, which was then annealed at 80°C for 7 minutes. After the annealing was completed, the nano stamp was separated from the substrate to obtain the perovskite MAPbl₃ patterned film.

Step 3, the LED device based on MAPbl₃ patterned film was prepared. A TPB transport layer was coated on the perovskite MAPbl₃ patterned film and a hole transport (blocking layer) layer of 7 nm MoOs was evaporated, subsequently 80 nm of Au was evaporated as the driving electrode to obtain a patterned MAPbl₃ red light LED device.

### Example 6 MAPbl₃ patterned film

Step 1, Pbl₂ film substrate and MAI film nano stamp were prepared. 0.5 M of Pbl₂ solution (solvent DMF:DMSO = 9:1) was spin coated onto the prepared ITO/ZnO/PEIE composite transparent conductive substrate, with spin coating parameters of 1500 rpm, 1000 rpm/s, and 30 s. After the spin coating was completed, annealing at 80 °C for a time period of 0.5 minute was accompanied to complete the preparation of Pbl₂ film substrate. For the preparation of MAI film, it was necessary to firstly treat the surface of the PMMA nano stamp with ultraviolet and ozone treatment methods for 15 minutes to improve the wettability of the surface, then a solution 3M of MAI in IPA was deposited on the surface of the PMMA nano stamp through a spin coating method, with spin coating parameters of 2000 rpm, 1000 rpm/s, and 60 s. After the spin coating was completed, annealing at 70°C for a time period of 0.5 minute was accompanied to complete the preparation of MAI film nano stamp.

Step 2, MAPbl₃ patterned film was prepared using the perovskite nanoimprinting. The substrate coated with Pbl₂ film was contacted with the nano stamp coated with MAI film, and a pressure of 2 MPa was applied for 0.5 minutes, which was then annealed at 120 °C for 3 minutes. After the annealing was completed, the nano stamp was separated from the substrate to obtain the perovskite MAPbl₃ patterned film.

Step 3, the LED device based on MAPbl₃ patterned film was prepared. A TPB transport layer was coated on the perovskite MAPbl₃ patterned film and a hole transport (blocking layer) layer of 7 nm MoOs was evaporated, subsequently 80 nm of Au was evaporated as the driving electrode to obtain a patterned MAPbl₃ red light LED device.

### Comparative example 1

This example was a method for preparing a patterned CH₃CH₃Pbl₃ film on an electronic-grade glass substrate, which specifically included the following steps:
step 1, cutting a square of 3cm×3cm from the CD-ROM disc, directly removing the surface protection layer of the disc and marking the front and back sides. Washing off the light green dye on the surface with ethanol, soaking the disc slice to be used in ethanol, and sonicating for 15 minutes, taking the same out and drying for later use;
step 2: weighing 2 g of the main agent of PDMS and 0.2 g of the curing agent, mixing them and stirring thoroughly, coating same to the surface of the CD-ROM optical grating slice layer, and then placing same in a drying oven to dry at 60 °C for 10 hours before demolding to obtain a CD-PDMS stamp based on the CD-ROM channel pattern;
step 3: formulating a Pbl₂ solution with a concentration of 0.9 mol/L, using DMF as the solvent, heating same in a nitrogen atmosphere to 65 °C and stirring for 40 minutes;
step 4, taking a 2cm×2cm of electronic grade glass sheet, and ultrasonic cleaning same in detergent, deionized water, acetone, and isopropanol, successively, each for 20 minutes, then taking out for drying, and then ultraviolet rays cleaning for 15 minutes;
step 5, in a nitrogen atmosphere, spin coating the Pbl₂ solution onto an electronic grade glass sheet at a speed of 2500 rpm for 3 seconds;
step 6, using a CD-PDMS pattern stamp to imprint the semi-humid Pbl₂ film for 10 seconds;
step 7, slowly demoulding the imprinted Pbl₂ film, and placing the glass substrate on a heating stage to anneal at 100 °C for 10 minutes;
step 8, taking 0.6 g of CH₃CH₂I particles and grinding same into powder form;
step 9: placing the annealed Pbl₂ film in a glass dish, evenly sprinkling the CH₃CH₃I powder around the film, and covering with a lip. Placing the glass dish on a heating stage and heating same to 160 °C for reacting 3 hours. After the completion of the reaction, removing it to obtain a patterned CH₃CH₂Pbl₃ film.

### Comparative example 2

This example was a method for preparing a patterned CH₃CH₃Pbl₃ film on a quartz SiO₂ substrate, which specifically included the following steps:
step 1: cleaning the quartz SiO₂ substrate with acetone and isopropanol, and treating same with ultraviolet and ozone for 15 minutes to improve the wettability of the substrate;
step 2: spin coating the a precursor solution of a mass fraction of 30 wt% CH₃CH₃Pbl₃ in DMSO on a SiO₂ substrate at room temperature at 3000 rpm for 30 seconds, then impressing the patterned PDMS substrate onto the CH₃CH₃Pbl₃ liquid film and applying a pressure of 25 kPa;
step 3: annealing the imprinted sample at 80 °C for 15 minutes to complete the preparation of the patterned CH₃CH₃Pbl₃ film.

The residual rate and LED device preparation yield of the perovskite patterned films in examples 1 to 6 and comparative examples 1 and 2 are shown in Table 1.

### Test method:

Residual rate: due to the fact that the residue is also a luminescent semiconductor material, the ratio of the luminescent residues occupying areas where they should not have occurred can be observed and calculated via a confocal fluorescence microscope, i.e., the residual rates among different patterning methods can be compared.

Yield: 20 LED light emitting devices were prepared based on each patterning method, and whether they can work was tested. The ratio of the number of workable LED devices to the total number of the prepared devices is defined as the yield of the patterning method.

**Table 1**

| / | Residual rate | Yield |
|---|---|---|
| Example 1 | 1.0% | 100% |
| Example 2 | 0.5% | 95% |
| Example 3 | 0.2% | 100% |
| Example 4 | 0.7% | 100% |
| Example 5 | 1.4% | 90% |
| Example 6 | 1.3% | 90% |
| Comparative example 1 | 8.0% | 80% |
| Comparative example 2 | 12.0% | 65% |

As can be seen from the above, compared to the comparative examples, the examples of the present disclosure take full advantage of the ion migration characteristics of organic lead halide perovskite materials and the wide-band-gap inertness of precursor PbX₂, wherein the nano stamp is used as the diffusion substrate of AY salt, and the perovskite pattern is accurately constructed on the PbX₂ substrate in a mode of combining contact imprinting and ion diffusion, so that the PbX₂/perovskite/PbX₂ coplanar structure is smoothly formed, where the perovskite pattern serves as an active area, while the rest PbX₂ naturally serves as a wide-band-gap insulation/inert isolation material; which can fundamentally avoid the residual and peeling problems that are prone to occur in the traditional nanoimprinting methods, resulting in a low residual rate and greatly improved yield of the obtained patterns. Moreover, the preparation method is simple, and the obtained perovskite patterned film is a coplanar surface smooth thin film, which can be directly used for the preparation of optoelectronic devices without any smoothing treatment subsequently and can be applied to various optoelectronic devices such as Mini/Micro-LED, solar cells, and optoelectronic detector, etc., and has a wide range of applications.

## Claims

1. A preparation method of a perovskite patterned film, wherein comprises the following steps:
step S1, coating a PbX₂ precursor on a substrate, and carrying out a first annealing to obtain a PbX₂ film substrate;
step S2, coating AY salt on the nano stamp with the pattern, and carrying out a second annealing to obtain an AY film nano stamp;
step S3, carrying out nanoimprinting on the PbX₂ film substrate through the AY film nano stamp to obtain an APb(X,Y)₃ perovskite patterned film;
wherein X and Y are respectively and independently one or more of I, Br and Cl, and the AY salt comprises amine salt and/or Cs-based salt.

2. The preparation method according to claim 1, wherein the PbX₂ precursor comprises PbX₂ and/or PbX₂ derivative, and the PbX₂ derivative comprises PbX₂-DMSO and/or PbX₂-NMP.

3. The preparation method according to claim 1 or 2, wherein the AY salt comprises one or more of MAY, FAY, and CsY.

4. The preparation method according to any one of claims 1 to 3, wherein the substrate material comprises one or more of transparent conductive glass, oxide, and organic polymer, and the nano stamp material comprises one or more of PDMS, PMMA, and Al₂O₃.

5. The preparation method according to claim 4, wherein the transparent conductive glass comprises one or more of ITO, FTO, and IZO; the oxide comprises one or more of Al₂O₃, TiO₂, SnO₂, and ZnO; and the organic polymer material comprises one or more of PMMA, PDMS, and PEIE.

6. The preparation method according to any one of claims 1 to 5, wherein the substrate material is one or more of ITO, ZnO, and PEIE.

7. The preparation method according to any one of claims 1 to 6, wherein in the step S1, the first annealing is carried out at a temperature of 60 to 80 °C for a time of 0.5 to 2 minutes.

8. The preparation method according to any one of claims 1 to 7, wherein in the step S2, the second annealing is carried out at a temperature of 50 to 70°C for a time of 0.5 to 2 minutes.

9. The preparation method according to any one of claims 1 to 8, wherein in the step S2, before coating the AY salt, it further comprises the step of carrying out a hydrophilic treatment on the surface of the nano stamp with the pattern; the hydrophilic treatment is to perform the ultraviolet and ozone treatments for 5 to 15 minutes.

10. The preparation method according to any one of claims 1 to 9, wherein in the step S3, the nanoimprinting is applied at a pressure of 0.5 to 2 MPa for a time of 0.5 to 2 minutes.

11. The preparation method according to any one of claims 1 to 10, wherein the step S3 further comprises a third annealing; the third annealing is carried out at a temperature of 80 to 120 °C, for a time of 3 to 7 minutes.

12. A perovskite patterned film, wherein it is obtained by the preparation method according to any one of claims 1 to 11.

13. Application of the perovskite patterned film according to claim 12 in an optoelectronic device.

14. A optoelectronic device, wherein comprises the perovskite patterned film according to claim 12.

15. The optoelectronic device according to claim 14, wherein the optoelectronic device is a solar cell, a Micro-LED, a Mini-LED, or an OLED.
